# EUROPEAN PATENT SPECIFICATION

(11) **EP 0 560 941 B1**
(45) Date of publication and mention of the grant of the patent: **16.10.1996**
(21) Application number: 92903694.5
(22) Date of filing: 09.12.1991
(51) Int. Cl.: H01L 39/24

(54) **PROCESS FOR DEPOSITING HIGH TEMPERATURE SUPERCONDUCTING OXIDE THIN FILMS**
VERFAHREN ZUM AUFBRINGEN VON HOCHTEMPERATUR-SUPRALEITENDEN OXIDDÜNNSCHICHTEN
PROCEDE DE DEPOT DE COUCHES MINCES D'OXYDES SUPRACONDUCTEURS A HAUTE TEMPERATURE

(30) Priority: 07.12.1990 US 624435
(43) Date of publication of application: 22.09.1993
(73) Proprietor: E.I. DU PONT DE NEMOURS AND COMPANY, Wilmington Delaware 19898 (US)
(72) Inventor: FACE, Dean, Willett, Greenville, DE 19807 (US)
(74) Representative: Jones, Alan John
(86) International application number: US9109047
(87) International publication number: WO9210857

(56) References cited:
- EP-A- 0 359 411
- EP-A- 0 435 765
- APPLIED PHYSICS LETTERS vol. 57, no. 19, 5 November 1990, NEW YORK, US pages 2019 - 2021; Lee.A.E. et al: 'Epitaxially grown sputtered LaAlO3 films'
- SOLID STATE TECHNOLOGY vol. 33, no. 8, August 1990, TULSA, US pages 83 - 87; Withers R.S. et al: 'High-Tc Superconducting Thin Films for Microwave Applications'
- EXTENDED ABSTRACTS OF THE 20TH CONFERENCE ON SOLID STATE DEVICES AND MATERIALS August 1988, TOKYO, JP pages 435 - 38; Yonezawa Y. et al: 'Preparation of High Tc Oxide Superconducting Films by Laser Annealing'
- APPLIED PHYSICS LETTERS vol. 54, no. 22, 29 May 1989, NEW YORK, US pages 2265 - 2267; Nuss M.C. et al: 'Propagation of tetrahertz bandwith electrical pulses on YBa2Cu3O7-à transmission lines on lanthanum aluminate'
- PATENT ABSTRACTS OF JAPAN vol. 15, no. 282 (C-0850)17 July 1991 & JP-A-3 097 870

## Description

### BACKGROUND OF THE INVENTION

### Field of the Invention

This invention relates to a process for producing thin films of high temperature superconducting oxides and other materials requiring high growth temperatures.

### References

The discovery of superconductivity at temperatures above 77 K, the boiling point of liquid nitrogen, in oxides such as YBa₂Cu₃O₇₋ₓ has stimulated a great deal of work over the past four years. Examples of other high temperature superconducting copper oxides which have been discovered during this period are the various Bi-based copper oxides , the various Tl-based copper oxides, the mixed Bi-Tl-based copper oxides and these superconducting oxides substituted with Pb and other substituents.

Much of the work relating to the use of these high temperature superconductors (HTSC) in microelectronic applications has been focused on the growth of high quality thin films. At microwave frequencies, 1-100 GHz, high quality superconducting thin films can have significantly lower values of surface resistance than copper or gold films. This low surface resistance is important for making high-performance thin film microwave circuits such as filters, resonators, and delay lines.

HTSC thin-films have been prepared by a number of deposition methods including evaporation, sputtering, laser ablation, and metallo-organic chemical vapor deposition (MOCVD), see, for example, R.W. Simon, Solid State Technology, p. 141, September, 1989 and J.

Talvacchio et al., SPIE Proceedings Vol. 1292, published by SPIE Bellingham, WA, (1990). In all of the thin film deposition processes for HTSC oxide materials, the substrate temperature is a critical parameter in determining the film quality. When the temperature of the substrate onto which the thin film of YBa₂Cu₃O₇₋ₓ is being deposited is low, i.e., less than about 400°C , the resulting film is amorphous and insulating. A high-temperature post-deposition anneal at 800-900°C in oxygen is required to convert the amorphous precursor film into a superconducting film with the correct crystal structure. This two-step process is referred to as a "post-anneal" process. However, under proper deposition conditions when a thin-film of YBa₂Cu₃O₇₋ₓ is deposited on a hot substrate, i.e., one at a temperature of about 550-750°C, the resulting thin-film is crystalline and superconducting directly as deposited. This process is referred to as an "in-situ" process. Films produced by an in-situ process have less surface roughness and generally superior properties when compared to films from a post anneal process. The in-situ deposition process has the added advantage of lower processing temperature requirements which makes the process compatible with a wider variety of substrate materials. In-situ processes based on laser ablation and sputtering have been found to produce high quality thin films of YBa₂Cu₃O₇₋ₓ on various substrates.

Appl. Phys. Lett, Vol 57 N°19, pp 2019-2021 discloses a process for depositing crystalline thin films of YBa₂Cu₃O₇ and LaAlO₃ onto a planar substrate by heating the back surface with a low-voltage Quartz lamp to 760°C and depositing the YBa₂Cu₃O₇ and LaAlO₃ on the front surface.

All in-situ processes require a method of heating substrates uniformly and reproducibly to the required deposition temperature. At the present time, the best methods for Y₁Ba₂Cu₃O₇₋ₓ thin films involve direct thermal and mechanical anchoring of the substrates to a heated block as discussed in R. W. Simon, SPIE Proceedings Vol. 1187, p 2, edited by T. Venkatesan, published by SPIE Bellingham, WA, (1989). The heated block must be made of a material that is compatible with an oxygen atmosphere and has good thermal conductivity such as nickel. Simple mechanical clamping of the substrates to the block has proven to be unreliable and is not useful for large area substrates because of subtrate breakage. Good thermal contact between the substrate and the block is usually provided by a compound with high thermal conductivity such as silver paste. However, this introduces the complication of removing the paste from the back of the substrate usually by polishing or etching. In addition, the direct thermal contact method is not compatible with the deposition of an in-situ film on both sides of the substrate. The thermal contacting compound can interact with the film on the back surface of the substrate and the compound is difficult to remove without damaging the film underneath.

The ability to deposit high quality superconducting thin films on both sides of a substrate is important for certain microwave circuit applications in order to improve performance and reliability. The film on one side of the substrate would serve as the ground plane while the film on the other side would be patterned into a microwave circuit. This invention provides a noncontact method of heating substrates to elevated temperatures for the purpose of depositing crystalline thin films of compounds, particularly films of high temperature superconducting oxides, requiring elevated growth temperatures on one or both sides of the substrate.

### SUMMARY OF THE INVENTION

This invention provides an improved in-situ process for depositing on a substrate having a front and back surface a crystalline thin film of a compound requiring an elevated growth temperature, i.e., a growth temperature of about 100°C to about 900°C. The process is especially useful for depositing a compound requiring a growth temperature of about 500°C to about 900°C and therefore is especially useful for depositing a film of an oxide, e.g., a high temperature superconducting oxide. The improvement comprises forming a crystalline thin film on the back surface of the substrate to provide a radiation absorbing layer, exposing directly only the back surface of the substrate, i.e., the surface of the substrate opposite the surface on which the thin film is deposited, to radiation from a radiant heat source thereby heating the substrate to the desired growth temperature and maintaining the radiation (and thereby the desired growth temperature) during the deposition of the thin film. Deposition can be carried out using any method, e.g., by sputtering, laser ablation, evaporation, metallo-organic chemical vapor depositon, spray pyrolysis or any other technique.

The substrate may be transparent to the radiation of the radiant heat source, but the back surface of the substrate is coated with a layer of material to absorb the radiation prior to the exposure to the radiation. This absorbing material can be the same compound as that of the thin film prepared in-situ using the process of this invention. This invention thus provides a process for preparing thin films of compounds requiring elevated growth temperatures, e.g., high temperature superconducting oxides, on opposite sides of a substrate. The two thin films can be of the same compound. Superconducting films on both sides of a planar substrate would be especially useful for certain microwave applications with one plane serving as the ground plane and the other patterned to form one or more elements of a microwave circuit. The thin film on the back surface of the substrate is deposited first and can be deposited by any method, e.g., by sputtering, laser ablation, evaporation, metallo-organic chemical vapor depositon, spray pyrolysis or any other technique. The film on the other surface of the substrate, i.e., the front surface of the substrate, is deposited using the in-situ method of this invention.

### BRIEF DESCRIPTION OF THE DRAWINGS

Figure 1 is a schematic drawing showing one way of practicing the in-situ process of the invention.

Figure 2 shows the measured superconducting transition for YBa₂Cu₃O₇₋ₓ films on the front and back surfaces of a 1 inch (2.5 cm) square LaAlO₃ substrate.

### DETAILED DESCRIPTION OF THE INVENTION

For brevity, the surface of the substrate on which the thin film is deposited by the in-situ process of the invention will be referred to herein as the "front surface" of the substrate. The opposite surface of the substrate will be referred to herein as the "back surface" of the substrate.

Many oxides are compounds which can be deposited by the method of this invention. Of particular interest are the high temperature superconducting oxides such as MBa₂Cu₃O₇₋ₓ, wherein M is Y or a rare earth metal and x is from about 0 to 0.3, the various Bi-based copper oxides , the various T1-based copper oxides, the mixed Bi-Tl-based copper oxides and these superconducting oxides substituted with Pb and other substituents.

The substrate can be any substrate suitable for the growth of the particular compound. Unit cell parameters, thermal expansion and lack of reaction with the compound are considerations that must be addressed in choosing a substrate. Substrates used successfully with other processes for the deposition of a particular compound will be useful for the deposition of crystalline thin films of the same compound using the process of the invention.

The substrate is heated by directly exposing the back surface of the substrate to radiation from a radiant heat source such as a quartz halogen lamp, a hot filament of Pt or Pt/Rh or commercially-available heater rods. The radiant source must be compatible with the deposition conditions. The source and the substrate must be positioned so that the proper amount of radiation impinges upon and is absorbed by the substrate thereby raising the temperature of the substrate to a temperature at which growth of the compound will occur.

Many common substrates such as sapphire and quartz which are used for thin film growth are transparent to the radiation from a radiant heat source. Therefore, prior to heating and film growth, it is necessary to coat the back surface of a transparent substrate with a radiation absorbing layer to absorb the radiation. Any material that absorbs the radiation can be used, although it is preferred to use a material having the same emissivity as that of the thin film compound to be deposited on the front surface of the substrate.

This invention also provides, for the first time, a process for depositing crystalline thin films on two sides of a substrate with the crystalline thin films being comprised of the same or different compounds requiring elevated growth temperatures. The process comprises the following steps. A crystalline thin film of the desired compound is formed on one surface of the substrate. The thin film can be deposited by any method, e.g., by sputtering, laser ablation, evaporation, metallo-organic chemical vapor depositon, spray pyrolysis or any other technique. The surface of the substrate containing the thin film, the back surface, is exposed to radiation from a radiant heat source thereby heating the substrate to the desired growth temperature of the desired compound of the second thin film to be formed on a second surface of the substrate, the front surface, and this exposure is maintained during the deposition of the second thin film so that the temperature of the substrate is maintained at the desired growth temperature . This second thin film can be also be deposited by any method, e.g., by sputtering, laser ablation, evaporation, metallo-organic chemical vapor depositon, spray pyrolysis or any other technique. The two thin films can both be comprised of superconductoring compounds, high temperature superconducting compounds or the same high temperature superconducting compound.

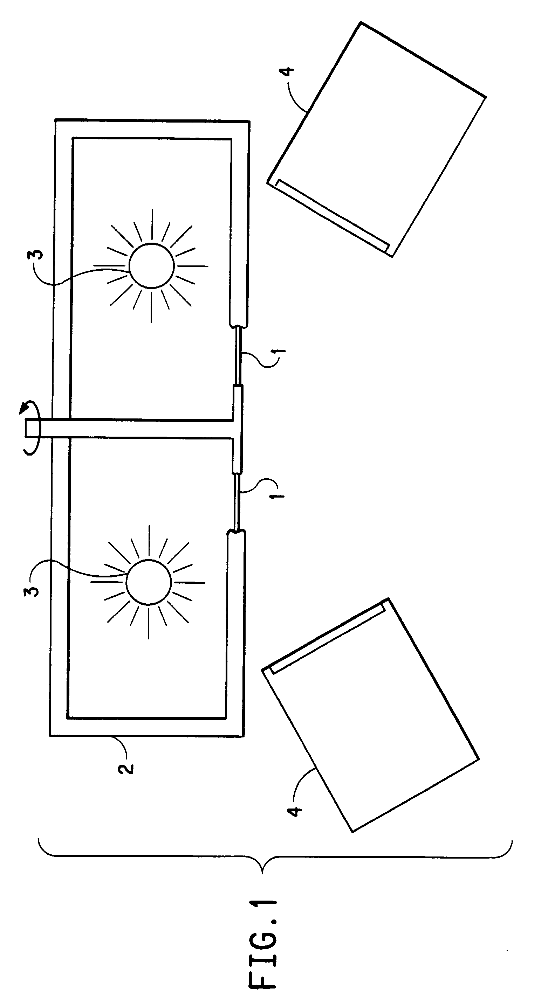

Figure 1 is a schematic drawing showing one way of practicing the in-situ process of the invention. In this embodiment, there is provision for depositing thin films on two substrates simultaneously. The two substrates **1** are placed in substrate holding openings in an enclosure **2** containing a radiant heat source **3**, one for each substrate. If the substrates are transparent to the radiation from the radiant heat sources, absorbing layers will have been deposited on the back surface of each substrate before they are placed in the enclosure **2**, and the substrates are placed in the holders so that the sides of the substrates with the absorbing layers are facing the radiant heat sources. Off-axis sputtering from two sputtering guns **4** is the method of deposition shown in the figure, although any deposition technique could be used. Means are provided to rotate the radiant heat source and substrate holder **2**. The components shown in Figure 1 are situated in a vacuum system in order to carry out sputtering.

The in-situ growth of a thin film of the high temperature superconducting oxide MBa₂Cu₃O₇₋ₓ, wherein M is Y or a rare earth metal and x is from about 0 to 0.3, can be carried out as follows. Single crystal LaAlO₃ substrates are preferred and are prepared by depositing a radiant heat absorbing layer on the back surface of the substrate. One choice for the absorbing layer is a thin film, about 1 µm thick, of MBa₂Cu₃O₇₋ₓ. It is not essential that this absorber layer film be MBa₂Cu₃O₇₋ₓ since any material that absorbs radiant heat from radiation source without degradation would be acceptable. This choice, however, enables the production of a planar substrate with MBa₂Cu₃O₇₋ₓ thin films on both sides. The first MBa₂Cu₃O₇₋ₓ film is deposited on the back surface of the substrate, the surface of the substrate to be directly exposed to the radiation from the radiant heat source. This film can be prepared by any technique. For example, a thin film of YBa₂Cu₃O₇₋ₓ can be deposited by co-evaporation of Y, BaF₂, and Cu in the Y:Ba:Cu atomic ratio of 1:2:3 followed by a wet O₂ anneal at 800-850°C as described by P. M. Mankiewich et al., Appl. Phys. Lett. 51, 1753 (1987). Films produced with this technique have transition temperatures, T_{c}'s, of 91-92 K and low microwave surface resistance, i.e., ten times lower than Cu at 80 K and 20 GHz. Two substrates, each with a thin film of YBa₂Cu₃07-x on the back surface, are then loaded into the substrate holder as shown in Figure 1. Quartz halogen lamps are the preferred radiant heat sources when depositing films of MBa₂Cu₃O₇₋ₓ because these lamps are particularly well suited for operation in the high pressures of oxygen which are useful in growing the MBa₂Cu₃O₇₋ₓ films. The substrates are heated up to about 700° C with the quartz lamps. For deposition by sputtering, off-axis sputtering using two sputter guns is preferred, as shown in Figure 1. Each sputter gun contains a sputtering target of stoichiometric YBa₂Cu₃O₇₋ₓ.

The onset of superconductivity T_{c} in superconducting films can determined by using an ac circuit to detect inductance changes in a sensing coil which is inductively coupled to the sample. The transition from a non-superconducting state to a superconducting state is detected by slowly varying the temperature and monitoring the resonant frequency. When the sample passes through the transition, a rapid change in the resonant frequency occurs and the transition temperature can be determined.

### EXAMPLE OF THE INVENTION

A planar substrate with YBa₂Cu₃O₇₋ₓ thin films deposited on both sides was prepared in the following manner. A 1 inch (2.5 cm) square [100] oriented single crystal LaAlO₃ substrate 0.5 mm thick was cleaned by the following process. The substrate was flooded with trichlorotrifluoroethane and methanol and scrubbed with a textured cloth. It was then spray rinsed with de-ionized water and dried with nitrogen. The substrate was next soaked in sulfuric acid for 10 minutes and then immersed in a water bath. The substrate was then rinsed with isopropanol, spray rinsed with de-ionized water and blow-dried with clean filtered nitrogen.

LaAlO₃ is transparent to the radiation used to heat the substrate and it is therefore necessary to deposit an absorbing layer on the back surface of the substrate. In order to produce a substrate with YBa₂Cu₃O₇₋ₓ thin films on both sides, the absorbing material used was YBa₂Cu₃O₇₋ₓ and it was formed as follows. The cleaned substrate was loaded into a turbomolecular pumped vacuum chamber with a base pressure of less than 8x10⁻⁷ mbar (8x10⁻⁵ Pa). Y, BaF₂ and Cu were co-evaporated onto the unheated LaAlO₃ substrate at the appropriate rates to give an atomic ratio of Y:Ba:Cu of 1:2:3 in the deposited film. The total deposition rate at the substrate was about 2 A/sec (0.2 nm/sec). Y and Cu were electron-beam evaporated from separate guns and the rates were controlled with Leybold-Heraeus Inficon Sentinel III electron impact emission sensors. BaF₂ was thermally evaporated from a covered molybdenum boat and the rate was controlled with a quartz crystal evaporation monitior. The co-evaporation was carried out in the presence of oxygen at 1x10⁻⁵ mbar (1x10⁻³ Pa). The total film thickness was about 4500 A (450 nm). The substrate containing the evaporated film was then placed in a standard quartz-lined tube furnace. The furnace was heated to 850°C at a rate of about 25°C/min and the film was in wet oxygen, formed by bubbling oxygen through de-ionized water. The temperature was maintained at 850°C for 30 minutes, and the film was then cooled in dry oxygen at a rate of about 5°C/min to about 500°C and then furnace cooled to room temperature (about 20°C).

The LaAlO₃ substrate with the YBa₂Cu₃O₇₋ₓ film on the back surface was then loaded into a cyro-pumped vacuum sputter deposition system [Leybold model L560] with a radiant heater and substrate holder configuration as schematically shown in Figure 1. The substrate was placed with the YBa₂Cu₃O₇₋ₓ film on the back surface directly exposed to the radiant heat source, a quartz halogen lamp. The internal temperature of the heater was measured with a thermocouple. The output of the internal thermocouple provides a feedback signal for a standard temperature controller which controls the power to the quartz lamps. This sputtering system is equipped with two rf magnetron sputtering guns with a 3" (7.6 cm) diameter YBa₂Cu₃O₇₋ₓ target in each gun. The guns are oriented in an "off-axis" configuration to reduce negative ion bombardment effects on the substrates. The substrate temperature was raised to about 700 °C at a rate 15°C/min. and maintained at this temperature during the deposition of the film by sputtering. The cryo-pump was throttled to reduce its pumping speed, and a gas flow of Ar (180 sccm, i.e, 180 standard cubic centimeters/minute) and O₂ (40 sccm) was used to raise the system pressure to 200 mtorr (26.7 Pa). The rf sputter guns were operated with 100 watts of rf power going to each of the two guns. This resulted in a deposition rate of about 250 Å/hr (25 nm/hr) at the substrate. The total deposition time was about 3 hours. The rf power and gas flow was turned off . The system was then backfilled with pure O₂ at a pressure of 200 torr (2.67x10⁴ Pa), and the substrate was cooled to room temperature at a rate of 15°C/min. The substrate was then removed from the system. The product is a substrate with YBa₂Cu₃O₇₋ₓ thin films on both sides.

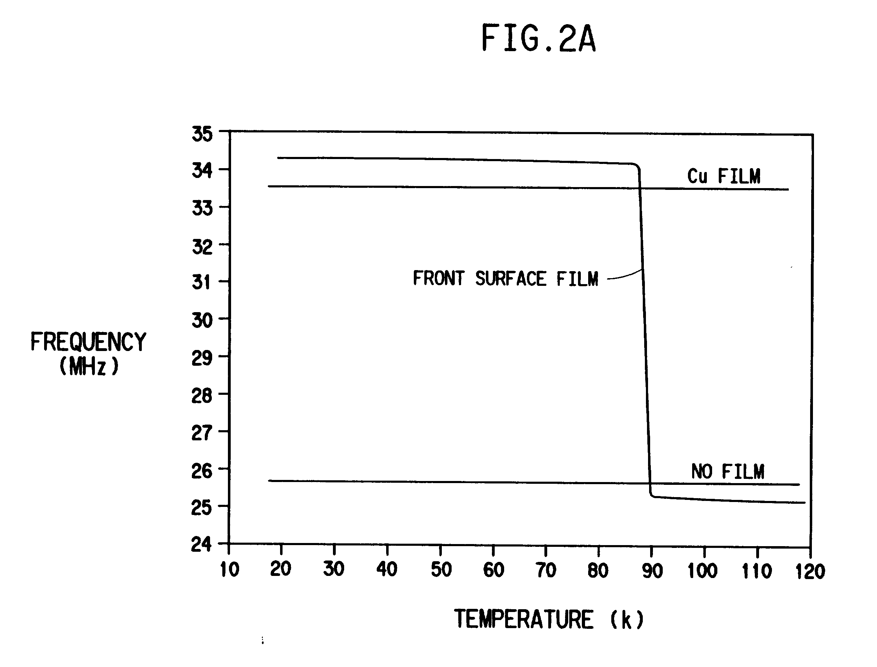

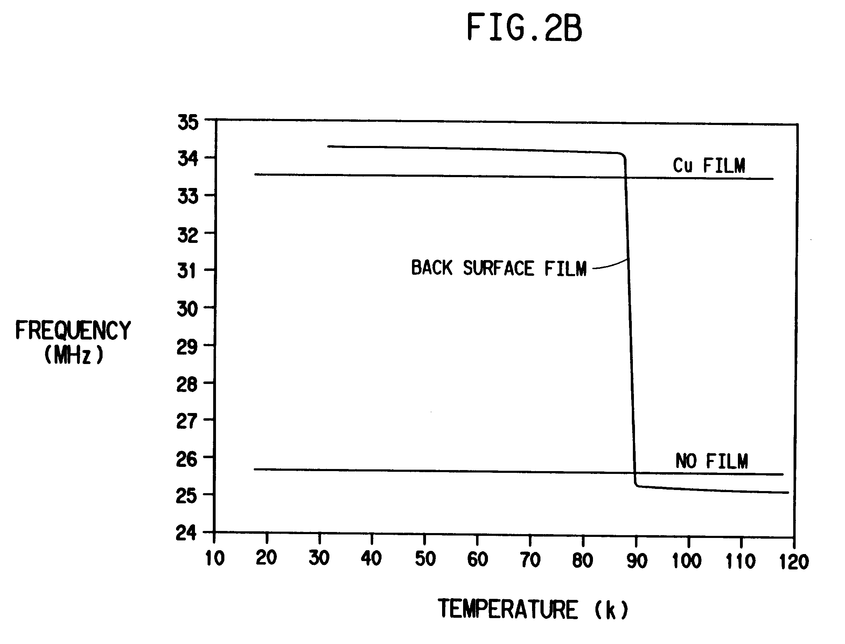

The inductively measured superconducting transition of the film produced by the in-situ method of this invention is shown in Figure 2. The value of T_{c}, about 90 K, as well as the narrow 1-2 K width of the superconducting transition are indicative of a very high quality film. The film on the back surface of this substrate also has a T_{c} of about 90 K and a very narrow superconducting transition as shown in Figure 2. The fact that the film on the back surface of the substrate was not degraded by the heating process shows that this technique can be used to produce high quality in-situ grown films on both sides of a LaAlO₃ substrate.

## Claims

1. A process of depositing *in-situ* a crystalline thin film of a high temperature superconducting oxide requiring elevated growth temperatures of from about 100°C to about 900°C onto a surface of a substrate having a front surface and an oppositely situated back surface, characterised in that a crystalline thin film is formed on the back surface of the substrate to provide a radiation absorbing layer, only said back surface coated with the radiation absorbing layer is directly exposed to radiation from a radiant heat source to heat said substrate to a predetermined growth temperature, and while maintaining said radiation, said thin film of a high temperature superconducting oxide is deposited only onto said front surface.

2. The process of claim 1 wherein the thin film formed on the back surface is a compound requiring high temperature for growth.

3. The process of either of claims 1 and 2 wherein the substrate is planar and said thin films are deposited on opposite sides of said planar substrate.

4. The process of any one of the preceding claims wherein the films on the front and back surfaces are the same high temperature superconducting oxide.

5. The process of any one of the preceding claims wherein said high temperature superconducting oxide is MBa₂Cu₃O₇₋ₓ, wherein M is Y or a rare earth metal and x is from about 0 to 0.3.

6. The process of any one of the preceding claims wherein said growth temperature is about 500°C to about 900°C.

7. The process of any one of the preceding claims wherein said thin film is deposited by sputtering.

8. The process of any one of the preceding claims wherein said substrate is comprised of a single crystal of LaAlO₃.

## Patentansprüche

1. Verfahren zur in-situ-Abscheidung einer kristallinen Dünnschicht aus einem Hochtemperatur-supraleitenden Oxid, das erhöhte Wachstumstemperaturen von etwa 100°C bis etwa 900°C erfordert, auf eine Oberfläche eines Substrats, das eine vordere Oberfläche und eine gegenüberliegende hintere Oberfläche aufweist, dadurch gekennzeichnet, daß eine kristalline Dünnschicht auf der hinteren Oberfläche des Substrats gebildet wird, um eine strahlungsabsorbierende Schicht zu erhalten, daß nur diese mit der strahlungsabsorbierenden Schicht beschichtete hintere Oberfläche direkt der Strahlung einer Wärmestrahlungsquelle ausgesetzt wird, so daß das Substrat auf eine vorbestimmte Wachstumstemperatur erhitzt wird, und daß, während die Strahlung aufrechterhalten wird, die Dünnschicht aus einem Hochtemperatur-supraleitenden Oxid nur auf der vorderen Oberfläche abgeschieden wird.

2. Verfahren gemäß Anspruch 1, wobei es sich bei der auf der hinteren Oberfläche gebildeten Dünnschicht um eine Verbindung handelt, die zum Wachstum eine hohe Temperatur erfordert.

3. Verfahren gemäß einem der Ansprüche 1 und 2, wobei das Substrat eben ist und die Dünnschichten auf einander gegenüberliegenden Seiten des ebenen Substrats abgeschieden werden.

4. Verfahren gemäß einem der vorangehenden Ansprüche, wobei es sich bei den Schichten auf der vorderen und auf der hinteren Oberfläche um dasselbe Hochtemperatur-supraleitende Oxid handelt.

5. Verfahren gemäß einem der vorangehenden Ansprüche, wobei es sich bei dem Hochtemperatur-supraleitenden Oxid um MBa₂Cu₃O₇₋ₓ handelt, wobei M Y oder ein Seltenerdmetall ist und x etwa 0 bis 0,3 beträgt.

6. Verfahren gemäß einem der vorangehenden Ansprüche, wobei die Wachstumstemperatur etwa 500°C bis etwa 900°C beträgt.

7. Verfahren gemäß einem der vorangehenden Ansprüche, wobei die Dünnschicht durch Aufstäuben abgeschieden wird.

8. Verfahren gemäß einem der vorangehenden Ansprüche, wobei das Substrat einen LaAlO₃-Einkristall umfaßt.

## Revendications

1. Procédé de dépôt *in situ* d'une pellicule cristalline mince d'un oxyde supraconducteur à haute température nécessitant des températures de croissance élevées, d'environ 100 °C à environ 900 °C, sur une surface d'un substrat ayant une surface avant et une surface arrière située à l'opposé, caractérisé en ce qu'une pellicule cristalline mince est formée sur la surface arrière du substrat pour fournir une couche absorbant une radiation, seulement ladite surface arrière revêtue avec la couche absorbant une radiation est directement exposée à la radiation d'une source de chaleur rayonnante pour chauffer ledit substrat à une température de croissance prédéterminée et en ce que, tout en maintenant ladite radiation, ladite pellicule mince d'un oxyde supraconducteur à haute température est déposée seulement sur ladite surface avant.

2. Procédé selon la revendication 1, dans lequel la pellicule mince formée sur la surface arrière est un composé nécessitant une haute température pour la croissance.

3. Procédé selon l'une des revendications 1 et 2, dans lequel le substrat est plan et lesdites pellicules minces sont déposées sur les côtés opposés dudit substrat plan.

4. Procédé selon l'une quelconque des revendications précédentes, dans lequel les pellicules sur les surfaces avant et arrière sont le même oxyde supraconducteur à haute température.

5. Procédé selon l'une quelconque des revendications précédentes, dans lequel ledit oxyde supraconducteur à haute température est MBa₂Cu₃O₇₋ₓ, où M est Y ou un métal des terres rares et x est d'environ 0 à 0,3.

6. Procédé selon l'une quelconque des revendications précédentes, dans lequel ladite température de croissance est environ 500 °C à environ 900 °C.

7. Procédé selon l'une quelconque des revendications précédentes, dans lequel ladite pellicule mince est déposée par pulvérisation cathodique.

8. Procédé selon l'une quelconque des revendications précédentes, dans lequel ledit substrat est constitué d'un monocristal de LaAlO₃.
